(19) Europäisches Patentamt
European Patent Office
Office européen des brevets

(11) **EP 3 167 298 B1**

(12) **EUROPÄISCHE PATENTSCHRIFT**

(45) Veröffentlichungstag und Bekanntmachung des Hinweises auf die Patenterteilung:
**26.04.2023   Patentblatt 2023/17**

(21) Anmeldenummer: **14758950.1**

(22) Anmeldetag: **04.09.2014**

(51) Internationale Patentklassifikation (IPC):
**G01R 31/333** (2006.01)     **G01R 31/26** (2020.01)

(52) Gemeinsame Patentklassifikation (CPC):
**G01R 31/263; G01R 31/3336; H02M 7/4835;**
H02M 7/7575; Y02E 60/60

(86) Internationale Anmeldenummer:
**PCT/EP2014/068821**

(87) Internationale Veröffentlichungsnummer:
**WO 2016/034233 (10.03.2016 Gazette 2016/10)**

(54) **VERFAHREN ZUM PRÜFEN EINES HOCHLEISTUNGS-HALBLEITERELEMENTS**

METHOD FOR TESTING A HIGH-POWER SEMICONDUCTOR ELEMENT

PROCÉDÉ DE CONTRÔLE D'UN ÉLÉMENT SEMI-CONDUCTEUR HAUTE PUISSANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.05.2017   Patentblatt 2017/20**

(73) Patentinhaber: **Siemens Energy Global GmbH & Co. KG**
**81739 München (DE)**

(72) Erfinder:
• **HAHN, Christoph**
**91052 Erlangen (DE)**
• **NEUBERT, Rolf**
**90736 Fürth (DE)**
• **WEINDL, Christian**
**96450 Coburg (DE)**
• **WENDLER, Thomas**
**97500 Ebelsbach-Gleisenau (DE)**
• **LUTHER, Matthias**
**91052 Erlangen (DE)**
• **SEMEROW, Anatoli**
**91058 Erlangen (DE)**

(56) Entgegenhaltungen:
**EP-A1- 2 443 468        EP-A1- 2 458 725**
**WO-A1-2014/056540**

**Beschreibung**

Die Erfindung betrifft ein Verfahren zum Prüfen eines Hochleistungs-Halbleiterelements von Stromrichtern der Hochspannungs-Gleichstrom-Übertragung mittels einer Prüfschaltung mit einer in eine Reihe geschalteten Anzahl von spannungsgeführten Stromrichtermodulen, die mit der Primärseite eines Hochstromtransformators verbindbar ist und bei dem die Sekundärseite des Hochstromtransformators mit dem Hochleistungs-Halbleiterelement verbindbar ist.

Die Hochspannungs-Gleichstrom-Übertragung (HGÜ) dient insbesondere der Energieübertragung mittels Gleichstrom über weite Entfernungen - in der Regel Entfernungen von rund 750 km aufwärts. Hierfür ist zwar ein vergleichsweise hoher technischer Aufwand für hochspannungstaugliche, aufwendige Stromrichter vonnöten, da elektrische Energie in Kraftwerken fast immer durch Synchron-Generatoren als Dreiphasenwechselstrom der Frequenz 50 Hz bzw. 60 Hz erzeugt wird. Allerdings führt die HGÜ ab bestimmten Entfernungen trotz des technischen Aufwands und der zusätzlichen Konverterverluste zu in der Summe geringeren Übertragungsverlusten als die Übertragung mit Dreiphasenwechselstrom.

Aus der Offenlegungsschrift WO 2014/056540 A1 ist ein modularer Multilevel-DC/DC-Wandler bekannt. Dieser Wandler weist einen ersten Teilumrichter und einen zweiten Teilumrichter auf, die miteinander unter Ausbildung einer Umrichterreihenschaltung in Reihe geschaltet sind. Der erste Teilumrichter und der zweite Teilumrichter sind über einen Transformator miteinander verbunden, so dass ein Austausch von elektrischer Leistung zwischen dem ersten Teilumrichter und dem zweiten Teilumrichter ermöglicht ist.

Die in den Stromrichtern oder in Statischen Blindleistungskompensatoren verwendeten Hochleistungs-Halbleiterelemente, insbesondere die Thyristorventile, müssen Leistungsprüfungen unterzogen werden. Dies erfolgt entweder in einer so genannten Back-to-back-Verbindung, bei der Gleich- und Wechselrichter "Rücken an Rücken" stehen, also im Gegensatz zu anderen HGÜ Anlagen, bei denen - wie oben beschrieben - oft große Distanzen zwischen den Stationen liegen, räumlich kaum voneinander getrennt sind, oder mittels einer synthetischen Prüfschaltung, d. h. konstruierten Prüfschaltungen, in denen der Prüfling angeschlossen werden kann und die die Spannungs- und Stromverläufe, denen der Prüfling im realen Betrieb unterliegt, nachbilden.

Durch die immer weiter ansteigende Übertragungsleistung von heutigen HGÜ-Systemen müssen für die Prüfung benötigte Back-to-back-Prüfeinrichtungen allerdings vergleichsweise groß dimensioniert und für die entsprechende Leistung ausgelegt sein. Synthetische Prüfschaltungen, wie sie beispielsweise aus IEC 60700-1, "Thyristor valves for high voltage direct current (HVDC) power transmission, Part1: Electrical Testing" IEC (International Electrotechnical Commission), Geneva, 2008; aus IEC 61954, "Static var compensators (SVC) - Testing of thyristor valves," IEC (International Electrotechnical Commission), Geneva, 2011; und aus IEEE (Institute of Electrical and Electronics Engineers), "IEEE 857, Guide for Testing of Thyristor Valves," IEEE, 1996 bekannt sind, benötigen hingegen nur 1 bis 2 % der Auslegungsgröße von vergleichbaren Back-to-back-Prüfsystemen, indem sie einen separaten Hochstrom- und Hochspannungskreis verwenden, die jeweils mit dem Prüfling verbindbar sind (d. h. über einen entsprechend ansteuerbaren Schalter oder ein Ventil mit diesem verbunden sind).

Die bisher bekannten synthetischen Prüfschaltungen umfassen hierbei einen oder mehrere LC-Schwingkreise zur Erzeugung der Hochspannung und daneben einen Hochstromkreis, der seinen Strom über einen Transformator aus dem Versorgungsnetz bezieht. Hierbei sind leicht unterschiedliche Konzepte auf der genannten Basis "Schwingkreis/Hochstrom" bekannt. Ein bekanntes Konzept der Anmelderin nutzt einen Freilaufpfad, der aus der Hochspannungsquelle getrieben wird, zur Überlagerung des Hochstromes. Andere bekannte Systeme nutzen ihren Schwingkreis nur zum Ein- und Ausschalten des Prüflings, während in der Hochstrom-Phase die Hochspannung mit einem Hilfsventil vom Prüfling getrennt wird.

In beiden Varianten sind die Ausschalt-Parameter des Prüflings von den Einschalt-Parametern abhängig und schränken so die Einstellung der Prüfbedingungen stark ein. Bedingt durch die Nachladung der Schwingkreise in Zusammenhang mit dem Hochstromkreis sind die aktuellen synthetischen Prüfschaltungen von der Netzfrequenz abhängig, d. h. auch Prüflinge, die später in einem 60-Hz-Netz betrieben werden, können bei der Prüfung nur bei 50 Hz belastet werden, so dass Anpassungen der Parameter nötig sind.

Zur Lösung dieses Problems kann - wie in einer nicht vorveröffentlichten Patentanmeldung der Anmelderin vorgesehen - eine Hochspannungsquelle verwendet werden, die eine Mehrzahl von in einer Reihe geschalteten spannungsgeführten Stromrichtermodulen (englisch: Voltage-Source Converter, kurz VSC) umfasst. Hierunter wird ein Modul verstanden, das einen Ladungsspeicher in der Art einer Batterie, z. B. einen Kondensator umfasst, wobei der Spannungswert an den Anschlüssen des Moduls durch entsprechende Ansteuerung von ebenfalls im Modul enthaltenen Schaltern mit einer Steuerspannung variiert werden kann.

Mit diesen Modulen ist es möglich, die real im HGÜ-Betrieb auftretenden Stromverläufe für den Prüfling sehr gut nachzubilden. Je nach erforderlicher Prüfung ist es hier jedoch gegebenenfalls erforderlich, einen Hochstromtransformator zu verwenden, um die für die Prüfung benötigten hohen Ströme zu erzielen. Wenn aus den VSC-Modulen ein Strom von beispielsweise 1 kA zu entnehmen ist, kann durch den Einsatz eines Einphasen-Transformators mit einem beispielhaften Übersetzungsverhältnis 1:10 für den Strom (oder 10:1 für die Spannung) ein trapezförmiger, unipolarer Strom erzeugt werden, der eine Amplitude von ca. 10 kA erreicht. Dies geschieht während der Prüfung in der Regel mehrfach in mehreren identischen, aufeinanderfolgenden Prüfzyklen.

Hierbei hat es sich als problematisch herausgestellt, dass nach einigen Prüfzyklen, in denen die VSC-Module die Primärseite des Hochstromtransformators mit einer entsprechenden Spannung belegen, extrem hohe Stromwerte auf der Primärseite des Transformators auftreten. Dies kann unter Umständen zu einer Beschädigung der beteiligten Komponenten führen.

Es ist daher Aufgabe der Erfindung, ein Verfahren der eingangs genannten Art anzugeben, welches eine Hochstromprüfung eines Hochleistungs-Halbleiterelements mittels einer beschriebenen Prüfschaltung bei einer besonders hohen Lebensdauer der verwendeten Komponenten ermöglicht.

Diese Aufgabe wird erfindungsgemäß gelöst durch ein Verfahren gemäß Anspruch 1. Dabei werden in einer zeitlichen Phase eines Prüfzyklus die spannungsgeführten Stromrichtermodule in einen undefinierten Zustand geschaltet.

Die Erfindung geht dabei von der Überlegung aus, dass die hohen Stromwerte auf der Primärseite des Hochstromtransformators aufgrund der Sättigung des Eisenkerns des Transformators entstehen. Der magnetische Fluss, der die Sättigung verursacht, entspricht hierbei im Wesentlichen der über die Zeit integrierten Spannung auf der Primärseite, der so genannten Spannungszeitfläche. Hierbei ist problematisch, dass auf der Sekundärseite des Transformators aufgrund der Ventileigenschaften des Prüflings nur Ströme in eine Richtung erlaubt sind, wodurch die Spannungszeitfläche im Laufe mehrerer Prüfzyklen immer weiter steigt. Um die Sättigung und damit die unzulässig hohen Ströme zu vermeiden, muss daher eine Kompensation der Spannungszeitfläche erfolgen. Dies könnte durch entsprechend komplexe Steuerverfahren während der Prüfzyklen erfolgen, was jedoch eine Verkomplizierung der Prüfschaltung bzw. des Prüfverfahrens bedeutet. Es hat sich jedoch überraschend herausgestellt, dass zur Kompensation der Spannungszeitfläche auch eine Schaltung der Stromrichtermodule in einen undefinierten Zustand während des Prüfens ausreichend ist. Unter einem undefinierten Zustand wird hierbei ein solcher Zustand verstanden, bei dem der Ladungsspeicher innerhalb des Moduls von den Anschlüssen des Moduls entkoppelt ist und die Anschlüsse des Moduls somit keinen definierten Spannungswert aufweisen. Dies wird durch die Topologie der spannungsgeführten Stromrichtermodule ermöglicht. Durch eine derartige Schaltung wird der Stromkreis praktisch freigegeben, so dass sich Ungleichgewichte wie z. B. eine aufgebaute Spannungszeitfläche und Sättigung des Eisenkerns aufgrund des natürlichen Strebens des Systems ins Gleichgewicht ausgleichen.

Ein Prüfzyklus des Verfahrens umfasst vorteilhafterweise folgende, durch Ansteuerung der spannungsgeführten Stromrichtermodule erzeugte, aufeinanderfolgende zeitliche Phasen:

- positive Spannung an der Primärseite des Hochstromtransformators;
- Nullspannung an der Primärseite des Hochstromtransformators;
- negative Spannung an der Primärseite des Hochstromtransformators.

Hierbei und im Folgenden wird darauf verwiesen, dass dem Fachmann klar ist, dass je nach Einbaurichtung des Prüflings und Messdefinition der Spannungsrichtung auch gleichbedeutend zuerst eine positive Spannung in der ersten Phase und eine negative Spannung in der dritten Phase angelegt werden kann. Nur zu Zwecken der Lesbarkeit wird hier und im Folgenden nur eine der beiden symmetrischen Optionen beschrieben, dem Fachmann ist aber klar, dass bei einer Redefinition der Spannungsrichtung auch die jeweils umgekehrte Anordnung umfasst ist.

Ein derartig ausgebildeter Prüfzyklus erfüllt den Prüfzweck, nämlich das Leiten eines hohen Stroms durch den Prüfling. In der ersten Phase einer positiven Spannung steigt der Strom auf der Primärseite an und demzufolge auch der hochtransformierte Strom auf der Sekundärseite. Nach Erreichen des gewünschten Stromes auf der Sekundärseite werden die spannungsgeführten Stromrichtermodule in einen durchleitenden Zustand geschaltet, so dass eine Spannung von 0 V an der Primärseite anliegt. Der induzierte Strom fließt dabei weiter und wird nur durch die Leitungswiderstände langsam kleiner. Anschließend wird eine umgekehrte Spannung auf der Primärseite angelegt, so dass der induzierte Strom praktisch abgebremst wird. Sobald der Strom auf der Sekundärseite auf 0 A sinkt, wird auch die Spannung auf der Primärseite wieder auf 0 V gesetzt und der Prüfzyklus ist beendet.

Es folgt die beschriebene zeitliche Phase des undefinierten Zustands der spannungsgeführten Stromrichtermodule im Prüfzyklus auf die soeben beschriebenen aufeinanderfolgenden zeitlichen Phasen. Hierdurch wird direkt die in den beschriebenen Phasen aufgebaute Spannungszeitfläche des Prüfzyklus wieder ausgeglichen. Die Länge der zeitlichen Phase des undefinierten Zustands wird hierbei derart bemessen, dass ein im Hochstromtransformator aufgebauter magnetischer Fluss abklingt. Dies ist im Wesentlichen gleichbedeutend zum Abbau der vorab aufgebauten Spannungszeitfläche. Die absolute Zeit, die dies dauert, ist dabei abhängig von einer Vielzahl von Faktoren wie z. B. dem Widerstand der Leitungen, den Eigenschaften des Eisenkerns des Transformators etc. Dem Fachmann ist aber bekannt, wie er bei gegebenen Eigenschaften der Schaltung und der Komponenten eine Zeit abschätzen kann, die für den Abbau der Spannungszeitfläche bzw. des magnetischen Flusses notwendig ist, so dass dieses Kriterium für den Fachmann klar und nacharbeitbar ist.

In erfindungsgemäßer Ausgestaltung des Verfahrens folgen mehrere gleichartige Prüfzyklen aufeinander. Hierdurch wird eine mehrfache Belastung des Prüflings mit dem geforderten Stromwert erreicht, wie dies zur Prüfung gemäß der eingangs genannten Normen erforderlich ist. Eine derartige Aufeinanderfolge von Prüfzyklen ohne die beschriebene Sättigung des Eisenkerns des Transformators wird durch die Zwischenschaltung von zeitlichen Phasen mit undefinierten Zuständen während jedes Prüfzyklus erst ermöglicht.

Die im Folgenden beschriebenen Strukturen von spannungsgeführten Stromrichtermodulen gelten bevorzugt für jedes der spannungsgeführten Stromrichtermodule. Die spannungsgeführten Stromrichtermodule sind vorzugsweise identisch ausgebildet. Das jeweilige spannungsgeführte Stromrichtermodul umfasst einen Kondensator und vier Transistoren mit jeweils einer Freilaufdiode in einer Vollbrücke, d. h. jeweils zwei in gleicher Richtung seriell geschaltete Transistoren, zwischen denen einer der externen Anschlüsse angeordnet ist, sind in gleicher Richtung miteinander und zum Kondensator parallel geschaltet. Hierdurch ergibt sich eine Form in der Art des lateinischen Großbuchstabens H. Hierbei entspricht der beschriebene undefinierte Zustand einem Zustand, in dem alle Transistoren in einem hochohmigen Zustand geschaltet sind, so dass keine definierte Spannung an den externen Anschlüssen anliegt. Vorzugsweise wird als jeweiliger Transistor ein Bipolartransistor mit isolierter Gate-Elektrode verwendet. Dies gilt insbesondere für jeden der Transistoren. Diese eignen sich besonders für die hier vorgesehene Anwendung im Hochleistungsbereich, da sie über eine hohe Vorwärts-Sperrspannung (derzeit bis 6,6 kV) verfügen und hohe Ströme (bis etwa 3 kA) schalten können. Hierbei können auch mehrere solcher Bipolartransistoren parallel geschaltet werden, um höhere Ströme schalten zu können.

Das jeweilige, vorzugsweise jedes spannungsgeführte Stromrichtermodul wird vorzugsweise für eine Nennspannung von mehr als 800 V und/oder einen Nennstrom von mehr als 500 A ausgelegt. Hierdurch wird eine übermäßig große Anzahl von Modulen vermieden, da die notwendige Kapazität für die Stromprüfung somit ausreichend ist.

In vorteilhafter Ausgestaltung umfasst die Prüfschaltung mehr als fünf, bevorzugt mehr als zehn spannungsgeführte Stromrichtermodule. Durch eine hohe Anzahl können feinere diskrete Spannungssprünge beim Erzeugen einer Spannungs-/Stromkurve für die Prüfung erreicht werden.

Das mit dem Verfahren in der Prüfschaltung geprüfte Hochleistungs-Halbleiterelement ist vorzugsweise ein Thyristor, wie er in einem netzgeführten Stromrichter insbesondere für die Hochspannungs-Gleichstrom-Übertragung zur Anwendung kommt.

Eine Prüfschaltung ist ausgelegt zum Prüfen eines Hochleistungs-Halbleiterelements von Stromrichtern der Hochspannungs-Gleichstrom-Übertragung nach dem beschriebenen Verfahren. Hierzu umfasst die Prüfschaltung die entsprechend notwendigen Komponenten wie einen Anschluss für den Prüfling, einen Hochstromtransformator und die spannungsgeführten Stromrichtermodule, aber auch eine entsprechende Steuerelektronik zum Aufladen der Stromrichtermodule und deren Ansteuern während der Prüfung.

Die mit der Erfindung erzielten Vorteile bestehen insbesondere darin, dass durch die Einstellung eines spannungsneutralen, undefinierten Zustands der VSC-Module während des Prüfzyklus, eine Sättigung des Transformatorkerns vermieden wird, so dass dieser hoch effizient genutzt werden kann. Hierdurch kann für die Hochstromprüfung ein über VSC-Module gespeister Hochspannungstransformator Anwendung finden, der die benötigten hohen Spannungen erreichen kann. Durch die Nutzung des Hochstromtransformators ist die Dimensionierung des Hochstromkreises sehr einfach: Da der Hochstromtransformator aus den Speicherkondensatoren der VSC-Module gespeist wird, ergeben sich sehr geringe Rückwirkungen auf das speisende Netz. Es werden lediglich die Verluste von Prüfling und Prüfschaltung aus dem Netz entnommen.

Die Prüffrequenz ist in weitem Bereich (z. B. 40 bis 70 Hz) einstellbar, so dass mit dem beschriebenen Verfahren Stromrichterventile mit ihren späteren Betriebsfrequenzen geprüft werden können. Die Frequenz des speisenden Netzes ist hierbei ohne Einfluss. Mit dem vorliegenden Verfahren sind neben den beschriebenen trapezförmigen, unipolaren Strömen auch beliebige andere Ströme in Form und Amplitude einstellbar. Die Steigung und Amplitude der Ströme kann durch entsprechende Spannungen der VSC-Module, die auf der Primärseite des Hochstromtransformators angelegt werden, flexibel gewählt werden. Hierdurch können die für einen Hochstromtest gemäß den eingangs genannten IEC-Normen erforderlichen Ströme erreicht werden.

Ausführungsbeispiele der Erfindung werden anhand einer Zeichnung näher erläutert. Darin zeigen:

FIG 1 einen Schaltplan einer synthetischen Prüfschaltung,

FIG 2 einen Schaltplan eines VSC-Moduls,

FIG 3 eine graphische Darstellung von Spannung und Strom während eines einzelnen Prüfzyklus in einer Simulation der synthetischen Prüfschaltung,

FIG 4 eine Hysteresekurve eines Transformators,

FIG 5 eine graphische Darstellung von Spannung und Strom während mehrerer Prüfzyklen ohne Kompensation der Spannungszeitfläche in einer Simulation der synthetischen Prüfschaltung, und

FIG 6    eine graphische Darstellung von Spannung und Strom während mehrerer Prüfzyklen mit Kompensation der Spannungszeitfläche in einer Simulation der synthetischen Prüfschaltung.

Gleiche Teile sind in allen Figuren mit denselben Bezugszeichen versehen.

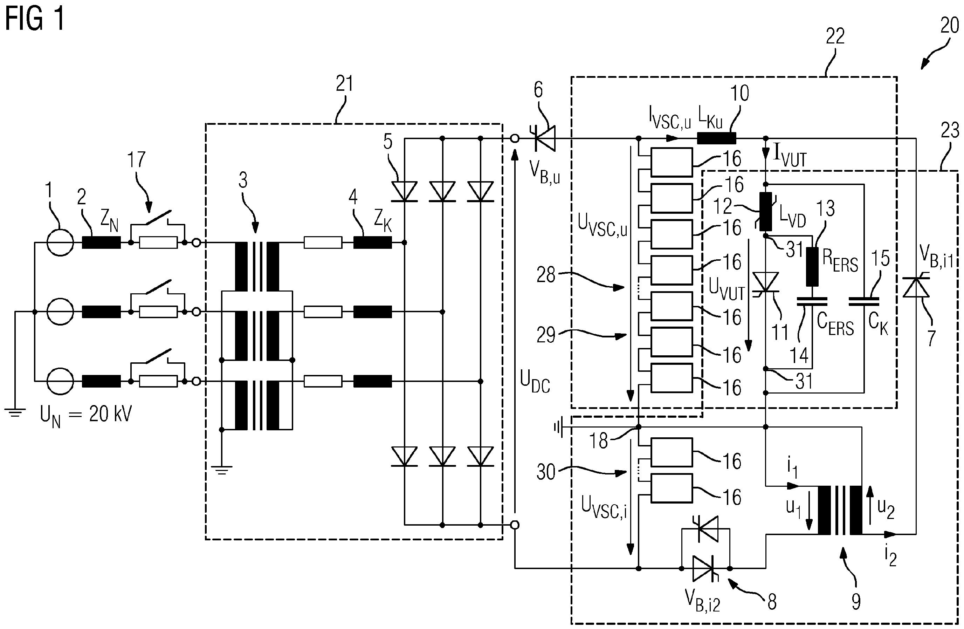

FIG 1 zeigt einen schematischen Schaltplan einer synthetischen Prüfschaltung 20 für ein Hochleistungs-Halbleiterelement 11, wie es in Stromrichtern für die Hochspannungs-Gleichstrom-Übertragung zur Anwendung kommt. In der linken Hälfte der FIG 1 ist ein übliches 20-kV-Wechselstromnetz gezeigt, welches durch eine dreiphasige Spannungsquelle 1 repräsentiert wird, in der FIG 1 dargestellt durch drei jeweils um 120 Grad phasenverschobene Spannungsquellen 1 in parallelen Stromwegen. Das 20-kV-Wechselstromnetz weist ebenfalls eine Netzimpedanz 2 auf, die mit $Z_n$ bezeichnet ist und ebenfalls in jedem der drei parallelen Stromwege an die Spannungsquellen 1 anschließend dargestellt ist.

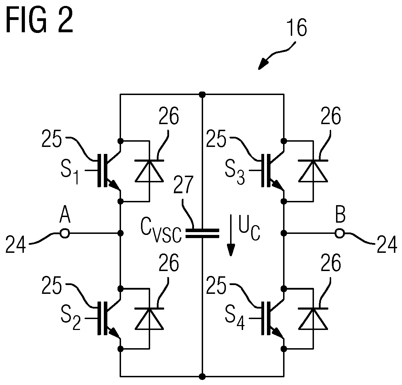

In den drei Stromwegen folgt als nächstes ein bedarfsweise schaltbar überbrückbarer Ladewiderstand 17 für die noch im Folgenden anhand der FIG 1 und FIG 2 noch erläuterten VSC-Module 16 (spannungsgeführte Stromrichtermodule) zu Beginn des Betriebs. Das 20-kV-Wechselstromnetz speist eine Hochgleichspannungsquelle 21, welche ausgehend vom Wechselstromnetz zunächst einen Dreiphasentransformator 3 speist. Die Hochgleichspannungsquelle 21 weist eine mit $Z_k$ bezeichnete Kommutierungsimpedanz 4 auf, die im Anschluss an den Dreiphasentransformator 3 anschließend dargestellt ist.

Die Hochgleichspannungsquelle 21 weist im Ausführungsbeispiel einen ungesteuerten Sechspulsgleichrichter 5 auf, der als Diodenbrücke in der Bauform B6 mit sechs Dioden ausgebildet ist. Andere Ausführungsformen können hierbei selbstverständlich auch andere Gleichrichter verwenden, so z. B. mit größeren Anzahlen von Dioden oder gesteuerte Gleichrichter. Die Hochgleichspannungsquelle 21 fungiert als Ladesystem für die VSC-Module 16 während des Prüfbetriebs und stellt die Gleichspannung $U_{DC}$ zur Verfügung.

Die Gleichspannung $U_{DC}$ ist über ein Sperrventil 6 an eine Reihe seriell geschalteter VSC-Module 16 angelegt. Diese bilden die eigentliche Hochspannungsquelle 28 für den im Folgenden noch erläuterten Prüfbetrieb und werden durch die Hochgleichspannungsquelle 21 lediglich vorab aufgeladen. Das Sperrventil 6 ist als Thyristor in Sperrrichtung mit der Bezeichnung $V_{B,u}$ ausgebildet und sperrt die Gleichspannung $U_{DC}$ während der im Folgenden noch erläuterten Spannungsprüfung von den VSC-Modulen 16 ab. Zwischen zwei VSC-Modulen 16 der Reihe ist eine Erdung 18 vorgesehen, die den Trennpunkt zwischen Hochspannungskreis 22 (VSC-Module 16 zwischen Sperrventil 6 und Erdung 18) und Hochstromkreis 23 (VSC-Module 16 zwischen Erdung 18 und positivem Pol der Hochgleichspannungsquelle 21) bildet. Die VSC-Module 16 werden damit in eine erste Reihe 29 des Hochspannungskreises 22 und eine zweite Reihe 30 des Hochstromkreises 23 getrennt.

Im nur schematisch dargestellten Schaltplan ist die Anzahl der VSC-Module 16 hierbei nicht festgelegt, unterschiedliche Ausführungsbeispiele können unterschiedliche (feste) Anzahlen von VSC-Modulen 16 vorsehen: Es ist eine Mehrzahl von $n_{VSC,u}$ VSC-Modulen 16 im Hochspannungskreis 22 und eine Mehrzahl von $n_{VSC,i}$ VSC-Modulen 16 im Hochstromkreis 23 vorgesehen, wobei die Gesamtzahl der VSC-Module damit $n_{VSC} = n_{VSC,u} + n_{VSC,i}$ beträgt. Über der Reihe 29 der $n_{VSC,u}$ VSC-Module 16 im Hochspannungskreis 22 liegt die Spannung Uvsc,u an, Über der Reihe 30 der nvsc,i VSC-Module 16 im Hochstromkreis 23 liegt die Spannung $U_{VSC,i}$ an.

Das Hochleistungs-Halbleiterelement 11, welches den auch mit VUT (Valve under Test) bezeichneten Prüfling darstellt, ist an den Anschlüssen 31 in einer sogleich beschriebenen Schaltung mit dem Hochspannungskreis 22 verbunden, indem diese den $n_{VSC,u}$ VSC-Modulen 16 im Hochspannungskreis 22 zwischen Sperrventil 6 und Erdung 18 über eine Kommutierungsdrossel 10 mit der Induktivität $L_{Ku}$ parallel geschaltet ist.

Die Schaltung des über die Anschlüsse 31 angeschlossenen Prüflings (im Ausführungsbeispiel ein Thyristor) umfasst dabei ein seriell vor dem Hochspannungs-Halbleiterelement 11 angeordnetes Sättigungsdrosselventil 12 mit der Induktivität $L_{VD}$, welches die Stromanstiegsgeschwindigkeit zum Prüfling zu Beginn des Stromflusses begrenzt und erst durch Eintreten der Sättigung seine Induktivität im Wesentlichen verliert. Weiterhin ist zu dem Prüfling und seinem vorgeschalteten Sättigungsdrosselventil 12 ein Steuerkondensator 15 mit der Kapazität $C_K$ parallel geschaltet.

Der in FIG 1 dargestellte Schaltplan zeigt zudem als Ersatzschaltbild parallel zum Prüfling geschaltet einen Widerstand 13 und einen Kondensator 14, die den Ersatzwiderstand $R_{ERS}$ bzw. die Ersatzkapazität $C_{ERS}$ des Prüflings darstellen. Ersatzwiderstand $R_{ERS}$ bzw. Ersatzkapazität $C_{ERS}$ des Prüflings sind in der FIG 1 zwar als reale Bauteile dargestellt, sind aber - wie bei Ersatzschaltbildern üblich - im Gegensatz zu den übrigen beschriebenen Bauteilen nicht in der realen Schaltung vorhanden, sondern stellen lediglich eine Repräsentation von intrinsischen Eigenschaften des Prüflings zu Zwecken der Darstellung und Berechnung dar. Der zur Kommutierungsdrossel 10 fließende Strom wird mit $I_{VSC,u}$ bezeichnet, der zum Prüfling fließende Strom mit $I_{VUT}$ und die über die Schaltung des Prüflings anliegende Spannung mit $U_{VUT}$.

Die $n_{VSC,i}$ VSC-Module 16 im Hochstromkreis 23 sind über ein antiparalleles, mit $V_{B,i2}$ bezeichnetes Sperrthyristorpaar 8 mit der Primärseite eines Hochstromtransformators 9 verbunden. Mit anderen Worten: Ein Pol der Primärseite des Hochstromtransformators 9 ist mit der Erdung 18, der andere Pol über das Sperrthyristorpaar 8 mit dem positiven Pol der Hochspannungsquelle 21 verbunden. Auf der Primärseite des Hochstromtransformators 9 liegt die Spannung $u_1$ an, hier fließt der Strom $i_1$.

Der Hochstromtransformator 9 ist durch eine geringere Windungszahl in der Spule der Sekundärseite gegenüber der Spule der Primärseite gekennzeichnet, so dass die an der Sekundärseite erzeugte Spannung $u_2$ zwar niedriger, der hier fließende Strom $i_2$ jedoch höher ist. Die Sekundärseite des Hochstromtransformators 9 ist über einen weiteren, mit $V_{B,i2}$ bezeichneten Sperrthyristor 7 in Schaltrichtung mit der Schaltung des Prüflings verbunden, d. h. ein Pol der Sekundärseite des Hochstromtransformators 9 ist wiederum mit der Erdung 18 verbunden, der andere Pol des Hochstromtransformators 9 über den Sperrthyristor 7 mit dem Eintritt der Schaltung des Prüflings, d. h. dem Sättigungsdrosselventil 12.

Wie bereits beschrieben bilden die insgesamt $n_{VSC}$ VSC-Module 16 zentrale Elemente innerhalb der synthetischen Prüfschaltung 20. Sie sind identisch ausgebildet. Ihr Aufbau wird anhand der FIG 2 erläutert.

FIG 2 zeigt den Schaltplan eines der VSC-Module 16. Das VSC-Modul 16 hat zwei externe Anschlüsse 24, bezeichnet mit A und B, und umfasst im bevorzugten Ausführungsbeispiel vier normalleitende Bipolartransistoren mit isolierter Gate-Elektrode (englisch: Insulated-Gate bipolar Transistor, kurz IGBT) 25, denen jeweils eine Freilaufdiode 26 zum Schutz vor einer Überspannung beim Abschalten parallel geschaltet ist. Prinzipiell sind aber auch andere Arten von Transistoren verwendbar.

Die IGBTs 26 sind mit einem Kondensator 27 mit der Kapazität Cvsc als zentrales Element in der Art einer Vollbrücke verschaltet, d. h. jeweils zwei in gleicher Richtung seriell geschaltete IGBTs 25, zwischen denen einer der externen Anschlüsse 24 angeordnet ist, sind in gleicher Richtung miteinander und zum Kondensator 27 parallel geschaltet. Die IGBTs 25 stellen Schalter $S_1...S_4$ dar, die mittels einer nicht weiter dargestellten Steuerelektronik einzeln ansteuerbar/ schaltbar sind. Dadurch kann die am Kondensator 27 anliegende Spannung Uc in beliebiger Richtung auf die externen Anschlüsse 24 zwischen A und B geschaltet werden. Zwischen den Anschlüssen 24 A und B liegt demnach je nach Schaltzustand der Schalter $S_1...S_4$, d. h. der IGBTs 25, entweder +Uc, -Uc oder 0 V an. Jede Stromrichtung ist dabei möglich. Eine Übersicht der für die hier beschriebene Anwendung relevanten Schaltzustände des VSC-Moduls 16 zusammen mit den dem Schaltzustand zugehörigen Zuständen der IGBTs 26 ist in der folgenden Tabelle gegeben:

| Funktion | S1 | S2 | S3 | S4 |
|---|---|---|---|---|
| Bypass ($U_{VSC}$ = 0 V) | 1(0) | 0 (1) | 1(0) | 0 (1) |
| $U_{VSC}$ = +$U_C$ | 1 | 0 | 0 | 1 |
| $U_{VSC}$ = -$U_C$ | 0 | 1 | 1 | 0 |

(fortgesetzt)

| Funktion | S1 | S2 | S3 | S4 |
|---|---|---|---|---|
| Undefiniert | 0 | 0 | 0 | 0 |

Zustand 0 bedeutet hierbei einen hochohmigen Zustand des jeweiligen IGBTs 26, Zustand 1 einen niederohmigen Zustand des jeweiligen IGBTs 26. In der ersten Zeile werden zwei alternative Zustandsmöglichkeiten für den Bypass-Zustand gezeigt. (Im Folgenden verwendete Verweise auf einzelne Zeilen der obigen Tabelle beziehen sich stets auf die Nummerierung beginnend nach der Kopfzeile.) Der Bypass-Zustand überbrückt den Kondensator 27, so dass die Spannung zwischen den externen Anschlüssen 24 A-B 0 V beträgt. Die in den folgenden Zeilen bezeichneten Schaltzustände bringen die Spannung des Kondensators 27 in unterschiedlichen Richtungen auf die externen Anschlüsse 24 A-B. Der in der letzten Tabellenzeile gezeigte Schaltzustand ist ein undefinierter Zustand, da jeder der IGBTs 26 hochohmig ist. Die übrigen möglichen Schaltzustände des VSC-Moduls 16 sind für die hier gezeigte Anwendung irrelevant.

Nachdem anhand der FIG 1 und der FIG 2 die Struktur der synthetischen Prüfschaltung 20 beschrieben wurde, wird nunmehr im Folgenden das Prüfverfahren beschrieben. Die Funktionsweise und die Interaktion der verschiedenen Komponenten aus der FIG 1 und der FIG 2 werden dabei ebenfalls beschrieben.

Die Hochgleichspannungsquelle 21 im linken Bereich der FIG 1 ist wie bereits beschrieben an ein dreiphasiges 20-kV-Drehstromnetz angeschlossen sowie mit der Reihenschaltung der VSC-Module 16 verbunden. Die Hochgleichspannungsquelle 21 hat somit die Aufgabe, die VSC-Module 16 abhängig von den Verlusten in der synthetischen Prüfschaltung 20 aufzuladen.

Während des Anfahrprozesses der synthetischen Prüfschaltung 20 sind die Kondensatoren 27 der VSC-Module 16 nicht geladen und somit nicht ansteuerbar. Die verwendeten VSC-Module 16 der Anmelderin im Ausführungsbeispiel haben eine Nennspannung von 1,6 kV und einen Nennstrom von 1 kA. In dem im Folgenden beschriebenen Ausführungsbeispiel sind 54 VSC-Module 16 vorgesehen und die Spannung der Hochgleichspannungsquelle 21 beträgt 50 kV.

Im Anfahrprozess sind die Ladewiderstände 17 aktiv, das Sperrventil 6 wird gezündet und aufgrund der beschriebenen Struktur laden sich somit die Kondensatoren 27 der VSC-Module 16 auf eine Spannung $U_C$ = $U_{DC}$ / $n_{VSC}$ = ca. 920 V auf. Sobald in jedem der VSC-Module 16 eine Spannung von etwa 800 V erreicht wird, wird die Steuerelektronik der VSC-Module 16 aktiv und die IGBTs 25 der VSC-Module 16 sind als Schalter $S_1...S_4$ steuerbar. Die VSC-Module 16 können somit graduell auf die gewünschte Nennspannung von 1,6 kV gebracht werden, indem bereits geladene VSC-Module 16 in ihrer Polung verändert werden, so dass sich ihre Spannung beim Laden der übrigen VSC-Module 16 zur Spannung der Hochgleichspannungsquelle 21 addiert.

Sobald der Anfahrprozess beendet ist, wird die Hochgleichspannungsquelle 21 ausgeschaltet und das Sperrventil 6 geht in einen Sperrzustand. Durch entsprechende zeitliche Ansteuerung der Steuerelektronik der VSC-Module 16 im Hochstromkreis 23 kann der Hochstromtransformator 9 an seiner Primärseite nunmehr mit beliebigen Spannungsverläufen beschaltet werden, die innerhalb der Grenzen von $+n_{VSC,u}$ * 1,6 kV und $-n_{VSC,u}$ * 1,6 kV liegen und mit 1,6 kV diskretisiert sind. Diese werden über die entsprechende Ansteuerung der Steuerelektroniken erzeugt. (N. B.: Die Funktion des Hochspannungskreises 22 und der Hochspannungsprüfung wird hier nicht beschrieben, da sie für das im Folgenden beschriebene neue Verfahren nicht relevant ist.) Da der Nennstrom eines verwendeten IGBTs 25 lediglich 1 kA beträgt, erhöht der Hochstromtransformator 9 den Strom auf den benötigen Maximalwert von etwa 6 kA. Das Sperrthyristorpaar 8 sperrt die Spannung der VSC-Module 16 vom Hochstromtransformator 9 ab, während diese geladen werden. Der Sperrthyristor 7 sperrt die Spannung des Hochspannungskreises 22 vom Hochstromkreis 23 ab, wenn letzterer nicht aktiv ist.

Sobald mittels entsprechender Ansteuerung der Steuerelektroniken der VSC-Module 16 im Hochstromkreis 23 eine positive Spannung an den Primärkreis des Hochstromtransformators 9 angelegt wird, und der Prüfling gezündet wird, beginnt der Primärstrom $i_1$ gemäß der folgenden Gleichung anzusteigen:

$$U_{VSC,i} = i_1 \left( R_1 + R'_2 \right) + L_t \frac{di_1}{dt}$$

Hierbei ist $U_{VSC,i}$ der Spannungsverlauf über der Reihe 30 der $n_{VSC,i}$ VSC-Module 16 im Hochstromkreis 23, $L_t$ die Kurzschluss-Blindinduktivität des Hochstromtransformators 9, und $R_1$, $R'_2$ (= $R_2$ auf die Primärseite transformiert) die ohmschen Widerstände des Hochstromtransformators 9. Mit dem Primärstrom $i_1$ steigt bei gezündetem Prüfling auch der Sekundärstrom $i_2$ mit $i_2 = i_1$ * $N_t$ an, wobei $N_t$ das Wicklungsverhältnis des Hochstromtransformators 9 ist. Da der Nennstrom der IGBTs 25 der VSC-Module 16 nur etwa 1 kA beträgt, der benötigte Strom für die Tests anhand der eingangs beschriebenen Normen aber etwa 6 kA beträgt, ist im Ausführungsbeispiel ein Wicklungsverhältnis von etwa 6:1 zu wählen.

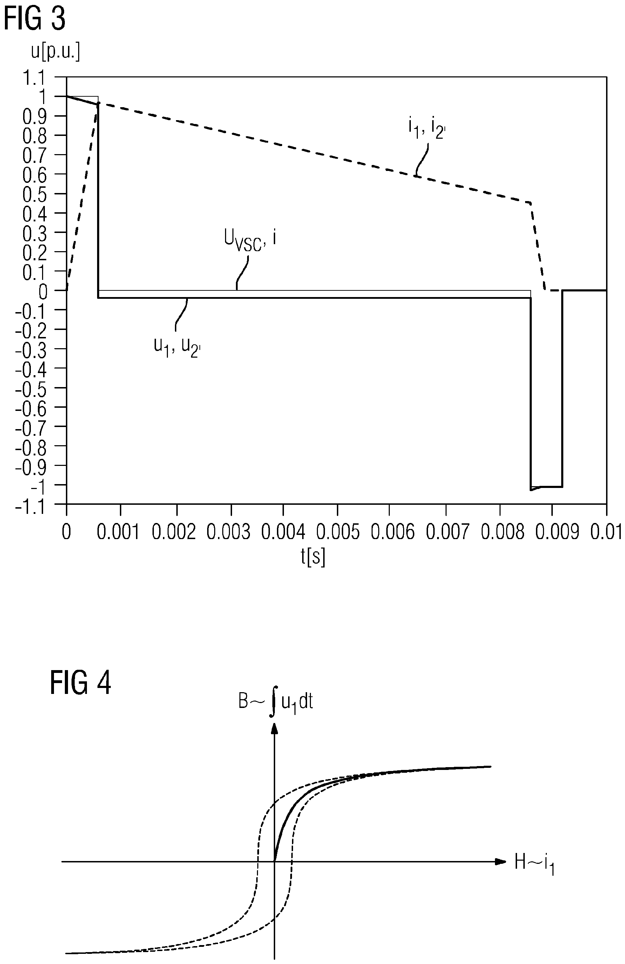

Die FIG 3 zeigt in einer graphischen Darstellung einen derartigen Spannungs- und Stromverlauf eines Prüfzyklus im Verfahren für die Hochstromprüfung. In dem Graph sind über einen Zeitraum von 0 bis 0,01 s die Spannungen $U_{VSC,i}$ (Spannung über der Reihe 30 der VSC-Module 16 im Hochstromkreis 23) und $u_1 = u'_2$ (Spannung der Primärseite des Transformators bzw. auf die Primärseite transformierte Spannung der Sekundärseite des Transformators) auf einer natürlichen Skala (links) in Einheiten der Gesamtspannung ($n_{VSC,i}$ * Uvsc) von -1,1 bis +1,1 dargestellt. Weiterhin sind die Ströme $i_1 = i'_2$ (Strom der Primärseite des Transformators bzw. auf die Primärseite transformierter Strom der Sekundärseite des Transformators) auf einer natürlichen Skala (rechts) in Einheiten des Nennstroms von -1,1 bis +1,1 dargestellt. Der Graph wurde anhand einer Simulation ermittelt.

Der gezeigte Spannungsverlauf Uvsc,i wird durch die Ansteuerung der Steuerelektroniken der VSC-Module 16 im Hochstromkreis 23 und dadurch resultierende Betätigung der jeweiligen Schalter $S_1...S_4$ durch eine entsprechende, nicht dargestellte Steuereinheit erzeugt. Mit dieser Hochspannungskurve kann der Prüfling umfassend getestet werden. Dies erfolgt anhand einer Mehrzahl von gleichartigen Prüfzyklen, die im Abstand von 0,02 s wiederholt werden. Einer dieser Prüfzyklen ist in FIG 3 dargestellt.

In einer ersten zeitlichen Phase des Prüfzyklus, in der FIG 3 von 0 s bis etwa 0,0007 s, wird eine positive Spannung in Höhe von nvsc,i * Uvsc angelegt. Die Ströme auf der Primär- und Sekundärseite des Hochstromtransformators 9 steigen im Wesentlichen linear anhand der obigen Gleichungen, wobei sie einen geringen Spannungsverlust über der Primärseite des Hochstromtransformators erzeugen (siehe leicht sinkende Kurve für $u_1$). Sobald der gewünschte Maximalstrom erreicht ist, im Ausführungsbeispiel ein Wert von 1 auf der rechten Skala, werden die VSC-Module 16 in den Bypass-Zustand geschaltet. Dies erfolgt in der zweiten zeitlichen Phase des Prüfzyklus von 0,0007 s bis ca. 0,0086 s. In dieser zweiten zeitlichen Phase beträgt $U_{VSC,i}$ = 0 V, während der Strom im Freilaufpfad fließt. Durch die Verluste durch die Widerstände $R_1$ und $R'_2$ bleibt der Strom jedoch in dieser Freilaufphase nicht konstant. Nach Ablauf einer gewissen Zeit, im Ausführungsbeispiel bei 0,0086 s werden die VSC-Module 16 so geschaltet, dass sie eine zur ersten zeitlichen Phase umgekehrte Spannung $-n_{VSC,i}$ * Uvsc an die Primärseite des Hochstromtransformators 9 anlegen. Wiederum anhand der obigen Gleichungen sinkt der Strom nun im Wesentlichen linear. Sobald der Strom des Hochstromtransformators 9 auf 0 A absinkt, ist der Prüfzyklus beendet und kann sofort oder nach Ablauf einer gewissen Zeit wiederholt werden.

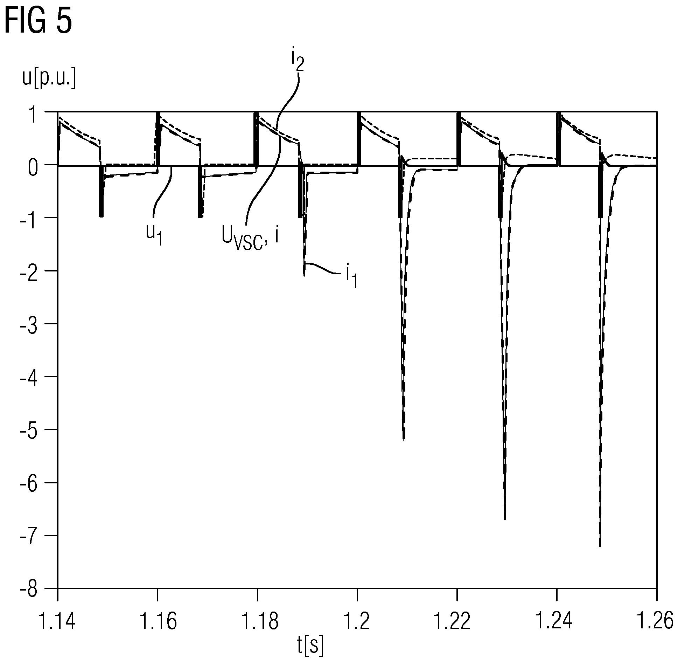

Wird der Prüfzyklus aus FIG 3 wiederholt, ergibt sich jedoch das Problem hoher Stromspitzen, wie im Folgenden noch anhand von FIG 5 erläutert wird. Dieses Problem ergibt sich durch die Sättigung des Eisenkerns des Hochstromtransformators 9, durch die die zuvor dargestellte Gleichung, die das Verhältnis zwischen $i_1$ und Uvsc,i beschreibt, ihre Gültigkeit verliert. Die Sättigung des Eisenkerns muss daher vermieden werden. Hierzu wird zunächst der Mechanismus, der zu dieser Sättigung im Zusammenhang mit dem in FIG 3 gezeigten Prüfzyklus führt, näher erläutert:

Der kritische Faktor hinsichtlich der Sättigung ist die so genannte Spannungszeitfläche. Nach dem Faraday'schen Induktionsgesetz ist die Korrelation zwischen der Primärseitenspannung $u_1$, dem magnetischen Fluss

Φ, der magnetischen Induktion B und der effektiven Transformatoreisenfläche $A_{Fe}$ wie folgt gegeben:

$$u_1 = \frac{d\Phi}{dt} = \frac{d}{dt} \iint \vec{B} \, d\vec{A} \approx A_{FE} \frac{dB}{dt}$$

$$\rightarrow B = \frac{1}{A_{Fe}} \int u_1 \, dt$$

Die magnetische Induktion B ist damit im Wesentlichen proportional zur Spannungszeitfläche. Weiterhin ergibt sich aus dem Oersted'schen Gesetz eine Korrelation zwischen dem Primärstrom des Hochstromtransformators 9, dem magnetischen Feld H und der effektiven Transformatoreisenlänge:

$$i_1 = \oint \vec{H} \, d\vec{s} \approx H l_{Fe}$$

$$\rightarrow H = \frac{i_1}{l_{Fe}}$$

Betrachtet man nun die Hysteresekurve des Eisenkerns, die in FIG 4 dargestellt ist, wird der Grund für die Stromspitzen deutlich: FIG 4 zeigt eine Prinzipskizze des Verhältnisses zwischen magnetischer Induktion B und magnetischem Feld H. FIG 4 zeigt eine dem Fachmann bekannte Hysteresekurve. Die magnetische Induktion B ist proportional zur Spannungszeitfläche. Überschreitet die Spannungszeitfläche einen bestimmten Wert, beginnt der Primärstrom im Hochstromtransformator 9 sehr schnell zu steigen. Dies wird durch die Sättigung des Eisenkerns verursacht.

Um die Sättigung zu vermeiden, muss die aufgebaute Spannungszeitfläche durch eine entsprechende negative Spannungszeitfläche während des Betriebs ausgeglichen werden. Dies ist für sinusförmige Spannungen und Ströme unproblematisch, da es stets ein Gleichgewicht zwischen positiven und negativen Spannungszeitflächen gibt. In der in FIG 1 gezeigten Prüfschaltung 20 ergibt sich aber das Problem, dass auf der Sekundärseite nur ein Strom in eine Richtung erlaubt ist, da der Prüfling eine Ventilcharakteristik hat. Der Spannungsverlust an den Widerständen $R_1$ und $R'_2$ hat somit stets nur eine Richtung und die Spannungszeitflächen der Primärseite des Transformators $u_1$ in FIG 3 gleichen sich nicht in positiver und negativer Richtung aus, selbst wenn die Spannung $U_{vsc,i}$ der VSC-Module 16 in der dritten zeitlichen Phase eine negative Spannungszeitfläche hat, die der positiven in der ersten zeitlichen Phase entspricht.

Anhand FIG 3 ist ersichtlich, dass während der positiven Spannung $U_{VSC,i}$ in der ersten zeitlichen Phase der ohmsche Spannungsverlust $i_1 * (R_1 + R'_2)$ an der Primärseite die effektive Spannungszeitfläche reduziert.

Für die negative Spannung der VSC-Module 16 $U_{VSC,i}$ in der dritten zeitlichen Phase erhöht der ohmsche Spannungsverlust die (negative) Spannungszeitfläche, da der Strom noch immer in die positive Richtung fließt, und nur die Spannung negativ wird. Somit ist die effektive negative Spannungszeitfläche immer größer als die effektive positive Spannungszeitfläche.

FIG 5 zeigt nunmehr ein zu FIG 3 gleichartiges Diagramm, dass jedoch einerseits in der Zeit erweitert ist und sich auf der Zeitskala von 1,14 s bis 1,26 s erstreckt, sowie hinsichtlich der Spannung (linke Skala) und des Stroms (rechts Skala) von -8 bis 1, in den Einheiten der FIG 3. FIG 5 zeigt die Situation anhand einer Simulation, wenn der in FIG 3 dargestellte Prüfzyklus ab dem Zeitpunkt 0 s im Abstand von 0,02 s ständig wiederholt wird, wie dies für eine Hochstromprüfung des Prüflings erforderlich ist. In dem in FIG 5 dargestellten Zeitraum (nach etwa 1,2 s) setzt die Sättigung des Eisenkerns ein. Der Primärstrom $i_1$ des Hochstromtransformators 9 beginnt, extrem hohe negative Werte anzunehmen. Im letzten der in FIG 5 gezeigten Prüfzyklen nimmt er Werte von mehr als -7 an.

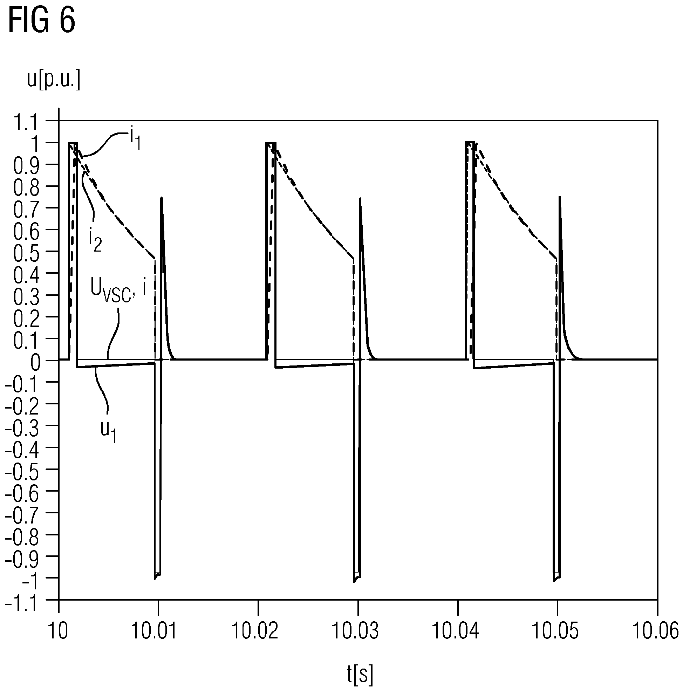

Um diese gezeigte Sättigung des Eisenkerns des Hochstromtransformators 9 durch die unsymmetrische Operation zu vermeiden, ist ein Verfahren nötig, welches die Spannungszeitfläche ausgleicht und kompensiert. Hierfür dient das in der FIG 6 gezeigte neue Verfahren.

In FIG 5 umfasste jeder Prüfzyklus folgende aufeinander folgende zeitliche Phasen:

- positive Spannung an den VSC-Modulen 16 (Schaltzustand der zweiten Zeile der obigen Tabelle)
- Nullspannung an den VSC-Modulen 16 (Schaltzustand "Bypass" in der ersten Zeile der obigen Tabelle)
- negative Spannung an den VSC-Modulen 16 (Schaltzustand der dritten Zeile der obigen Tabelle)

Der im neuartigen, hier beschriebenen Verfahren gewählte Ablauf der zeitlichen Phasen, der eine Kompensation der Spannungszeitfläche ermöglicht, gestaltet sich nunmehr wie folgt:

- positive Spannung an den VSC-Modulen 16 (Schaltzustand der zweiten Zeile der obigen Tabelle)
- Nullspannung an den VSC-Modulen 16 (Schaltzustand "Bypass" in der ersten Zeile der obigen Tabelle)
- negative Spannung an den VSC-Modulen 16 (Schaltzustand der dritten Zeile der obigen Tabelle)
- keine definierte Spannung an den VSC-Modulen 16 (Schaltzustand der letzten Zeile der obigen Tabelle)

Die letzte, neu hinzugekommene zeitliche Phase des Prüfzyklus, im Ausführungsbeispiel direkt nach der Anwendung der negativen Spannung, ermöglicht eine automatische Kompensation der Spannungszeitfläche im Eisenkern des Hochstromtransformators 6. Die Länge der zeitlichen Phase des undefinierten Zustands ist dabei so bemessen, dass der im Hochstromtransformator 9 aufgebaute magnetische Fluss vollständig abklingt.

Der beschriebene neue Prüfzyklus ist in FIG 6 dargestellt, die hinsichtlich der Skalen identisch zu FIG 4 gestaltet ist, jedoch wird hier ein alle 0,02 s wiederholter Prüfzyklus nach mehr als 10 s simuliert. Dementsprechend bewegt sich die Skala der Zeitachse zwischen 10 s und 10,06 s. Wie erkennbar ist, sind auch nach einer Vielzahl von Prüfzyklen nach 10 s keine übermäßig hohen Ströme erkennbar.

Auch wenn aktiv keine positive Spannung an die Primärseite der Hochstromtransformators 9 angelegt wird, verursacht die Magnetisierung des Eisenkerns durch den undefinierten Schaltzustand einen kleinen negativen Primärstrom, der durch die Freilaufdioden 26 der jeweiligen IGBTs 25 fließt, wodurch eine positive Spannung an der Primärseite des Hochstromtransformators 9 entsteht (siehe Spannungsspitze von $U_{VSC,i}$ kurz nach der dritten zeitlichen Phase).

Das beschriebene Phänomen basiert auf einem fundamentalen physikalischen Prinzip: In einem physikalischen System ist der einzige stabile Zustand derjenige, in dem alle physikalischen Größen im Gleichgewichtszustand sind. Um diesen stabilen Zustand zu erreichen, streben alle physikalischen Systeme zum energetischen Minimum. Durch den undefinierten Zustand der VSC-Module 16 wird dem Hochstromtransformator 9 die Möglichkeit gegeben, dieses energetische Minimum zu erreichen und die Spannungszeitfläche auszugleichen.

Bezugszeichenliste

1    dreiphasige Spannungsquelle
2    Netzimpedanz
3    Dreiphasentransformator
4    Kommutierungsimpedanz
5    Sechspulsgleichrichter
6    Sperrventil
7    Sperrthyristor
8    Sperrthyristorpaar
9    Hochstromtransformator
10   Kommutierungsdrossel
11   Hochleistungs-Halbleiterelement
12   Sättigungsdrosselventil
13   Widerstand
14   Kondensator
15   Steuerkondensator
16   VSC-Modul
17   Ladewiderstand
18   Erdung
20   synthetische Prüfschaltung
21   Hochgleichspannungsquelle
22   Hochspannungskreis
23   Hochstromkreis
24   Anschluss
25   IGBT
26   Freilaufdiode
27   Kondensator
28   Hochspannungsquelle
29   erste Reihe
30   zweite Reihe
31   Anschluss

Patentansprüche

1.  Verfahren zum Prüfen eines Hochleistungs-Halbleiterelements (11) von Stromrichtern einer Hochspannungs-Gleichstrom-Übertragung mittels einer Prüfschaltung (20) mit einer in eine Reihe geschalteten Mehrzahl von spannungsgeführten Stromrichtermodulen (16), die mit der Primärseite eines Hochstromtransformators (9) verbunden ist und wobei die Sekundärseite des Hochstromtransformators (9) mit dem Hochleistungs-Halbleiterelement (11) verbunden ist, wobei die spannungsgeführten Stromrichtermodule (16) jeweils einen Kondensator (27) und vier Transistoren (25) mit jeweils einer Freilaufdiode (26) in einer Vollbrücke umfassen, bei dem eine Hochspannungsquelle (28) verwendet wird, die die in der Reihe geschalteten spannungsgeführten Stromrichtermodule (16) umfasst, mit diesen Stromrichtermodulen (16) in einem Hochspannungs-Gleichstrom-Übertragungs-Betrieb auftretende Stromverläufe für das Hochleistungs-Halbleiterelement (11) nachgebildet werden, wobei der Hochstromtransformator (9) verwendet wird, um für die Prüfung benötigte hohe Ströme zu erzielen, bei dem ein Prüfzyklus verwendet wird, der folgende, durch Ansteuerung der spannungsgeführten Stromrichtermodule (16) erzeugte, zeitlich aufeinander folgende Phasen A bis D umfasst:

    A: positive Spannung an der Primärseite des Hochstromtransformators (9);
    B: Nullspannung an der Primärseite des Hochstromtransformators (9) ;
    C: negative Spannung an der Primärseite des Hochstromtransformators (9), bei dem in einer zeitlich direkt nach der negativen Spannung folgenden Phase D des Prüfzyklus die spannungsgeführten Stromrichtermodule (16) in einen undefinierten Zustand geschaltet werden, der ein hochohmiger Zustand aller Transistoren (25) der Stromrichtermodule (16) ist, und bei dem die Länge der zeitlichen Phase D des undefinierten Zustands derart bemessen wird, dass ein im Hochstromtransformator (9) aufgebauter magnetischer Fluss abklingt, wobei mehrere gleichartige Prüfzyklen aufeinander folgen, wobei jeder Prüfzyklus die Phasen A, B, C und D in dieser Reihenfolge umfasst.

2. Verfahren nach Anspruch 1, bei dem ein Bipolartransistor (25) mit isolierter Gate-Elektrode (25) als jeweiliger Transistor (25) verwendet wird.

3. Verfahren nach einem der vorhergehenden Ansprüche, bei dem das jeweilige spannungsgeführte Stromrichtermodul (16) für eine Nennspannung von mehr als 800 V und/oder einen Nennstrom von mehr als 500 A ausgelegt wird.

4. Verfahren nach einem der vorhergehenden Ansprüche, bei dem mehr als fünf, bevorzugt mehr als zehn, spannungsgeführte Stromrichtermodule (16) verwendet werden.

5. Verfahren nach einem der vorhergehenden Ansprüche, bei dem ein Thyristor (11) als Hochleistungs-Halbleiterelement (11) verwendet wird.

6. Prüfschaltung (20) mit einer Steuerelektronik, eingerichtet zum Prüfen eines Hochleistungs-Halbleiterelements (11) von Stromrichtern einer Hochspannungs-Gleichstrom-Übertragung nach einem Verfahren gemäß einem der vorhergehenden Ansprüche, mit einer in eine Reihe geschalteten Mehrzahl von spannungsgeführten Stromrichtermodulen (16), die mit der Primärseite eines Hochstromtransformators (9) verbunden ist und wobei die Sekundärseite des Hochstromtransformators (9) mit dem Hochleistungs-Halbleiterelement (11) verbunden ist, wobei die spannungsgeführten Stromrichtermodule (16) jeweils einen Kondensator (27) und vier Transistoren (25) mit jeweils einer Freilaufdiode (26) in einer Vollbrücke umfassen, mit einer Hochspannungsquelle (28), die die in der Reihe geschalteten spannungsgeführten Stromrichtermodule (16) umfasst, wobei die Prüfschaltung (20) eingerichtet ist mit diesen Stromrichtermodulen (16) im Hochspannungs-Gleichstrom-Übertragungs-Betrieb auftretende Stromverläufe für das Hochleistungs-Halbleiterelement (11) nachzubilden und dabei mittels des Hochstromtransformators (9) für die Prüfung benötigte hohe Ströme zu erzielen, wobei die Prüfschaltung (20) eingerichtet ist einen Prüfzyklus zu verwenden, der folgende, durch Ansteuerung der spannungsgeführten Stromrichtermodule (16) erzeugte, zeitlich aufeinander folgende Phasen A bis D umfasst:

A: positive Spannung an der Primärseite des Hochstromtransformators (9);
B: Nullspannung an der Primärseite des Hochstromtransformators (9) ;
C: negative Spannung an der Primärseite des Hochstromtransformators (9),
wobei in einer zeitlich direkt nach der negativen Spannung folgenden Phase D des Prüfzyklus die spannungsgeführten Stromrichtermodule (16) in einen undefinierten Zustand geschaltet sind, der ein hochohmiger Zustand aller Transistoren (25) der Stromrichtermodule (16) ist, wobei die Länge der zeitlichen Phase des undefinierten Zustands derart bemessen ist, dass ein im Hochstromtransformator (9) aufgebauter magnetischer Fluss abklingt, und
wobei die Prüfschaltung dazu eingerichtet ist, mehrere gleichartige Prüfzyklen aufeinander folgen zu lassen, wobei jeder Prüfzyklus die Phasen A, B, C und D in dieser Reihenfolge umfasst. 1

## Claims

1. Method for testing a high-power semiconductor element (11) of power converters in high-voltage direct current transmission by means of a test circuit (20) comprising a plurality of series-connected voltage-regulated power converter modules (16) which are connected to the primary side of a high-current transformer (9), and wherein the secondary side of the high-current transformer (9) is connected to the high-power semiconductor element (11), wherein the voltage-regulated power converter modules (16) each comprise a capacitor (27) and four transistors (25), respectively with a freewheeling diode (26) in a full bridge circuit,

in which use is made of a high-voltage source (28) which comprises the series-connected voltage-regulated power converter modules (16), these power converter modules (16) are used to simulate current profiles for the high-power semiconductor element (11) which occur in a high-voltage direct current transmission mode, wherein the high-current transformer (9) is used to achieve high currents required for the test, in which use is made of a test cycle which comprises the following temporally sequential phases A to D, which are generated by the control of the voltage-regulated power converter modules (16):

A: positive voltage on the primary side of the high-current transformer (9);
B: zero voltage on the primary side of the high-current transformer (9);
C: negative voltage on the primary side of the high-current transformer (9),

in which, in a phase D of the test cycle that directly temporally follows the negative voltage, the voltage-regulated power converter modules (16) are switched to an undefined state which is a high-resistance state of all the transistors (25) of the power converter modules (16), and in which the temporal phase D duration of the undefined state is dimensioned for the decay of a magnetic flux accumulated in the high-current transformer (9), wherein a plurality of identical test cycles proceed in sequence, wherein each test cycle comprises the phases A, B, C and D in this order.

2. Method according to Claim 1, in which an insulated gate bipolar transistor (25) is used as the respective transistor (25) .

3. Method according to one of the preceding claims, in which the respective voltage-regulated power converter module (16) is designed for a rated voltage exceeding 800 V and/or for a rated current exceeding 500 A.

4. Method according to one of the preceding claims, in which more than five, preferably more than ten, voltage-regulated power converter modules (16) are used.

5. Method according to one of the preceding claims, in which a thyristor (11) is used as the high-power semiconductor element (11) .

6. Test circuit (20) having control electronics, designed for testing a high-power semiconductor element (11) of power converters in high-voltage direct current transmission by a method according to one of the preceding claims,

     having a plurality of series-connected voltage-regulated power converter modules (16) which are connected to the primary side of a high-current transformer (9), and wherein the secondary side of the high-current transformer (9) is connected to the high-power semiconductor element (11), wherein the voltage-regulated power converter modules (16) each comprise a capacitor (27) and four transistors (25), respectively with a freewheeling diode (26) in a full bridge circuit, having a high-voltage source (28) which comprises the series-connected voltage-regulated power converter modules (16), wherein the test circuit (20) is configured to use these power converter modules (16) to simulate current profiles for the high-power semiconductor element (11) which occur in the high-voltage direct current transmission mode and in the process to use the high-current transformer (9) to achieve high currents required for the test, wherein the test circuit (20) is configured to use a test cycle which comprises the following temporally sequential phases A to D, which are generated by the control of the voltage-regulated power converter modules (16):

     A: positive voltage on the primary side of the high-current transformer (9);
     B: zero voltage on the primary side of the high-current transformer (9);
     C: negative voltage on the primary side of the high-current transformer (9),

wherein, in a phase D of the test cycle that directly temporally follows the negative voltage, the voltage-regulated power converter modules (16) are switched to an undefined state which is a high-resistance state of all the transistors (25) of the power converter modules (16), wherein the temporal phase duration of the undefined state is dimensioned for the decay of a magnetic flux accumulated in the high-current transformer (9), and wherein the test circuit is configured to allow a plurality of identical test cycles to proceed in sequence, wherein each test cycle comprises the phases A, B, C and D in this order.

## Revendications

1. Procédé de contrôle d'un élément (11) à semiconducteur de haute puissance d'onduleurs d'un transport de courant continu à haute tension, au moyen d'un circuit (20) de contrôle, ayant une pluralité de modules (16) d'onduleur sous tension, qui sont montés en série et qui sont reliés au côté primaire d'un transformateur (9) de courant maximum, et dans lequel le côté secondaire du transformateur (9) de courant maximum est relié à l'élément (11) à semiconducteur de haute puissance,

     dans lequel les modules (16) d'onduleur sous tension comprennent chacun un condensateur (27) et quatre transistors (25) ayant chacun, en un pont complet, une diode (26) de roue libre, dans lequel on utilise une source (28) de haute tension, qui comprend les modules (16) d'onduleur sous tension montés en série, on reproduit par ces modules (16) d'onduleur, pour l'élément (11) à semiconducteur à haute puissance, des courbes de courant se produisant dans un fonctionnement de transport de courant continu à haute tension, dans lequel on utilise le transformateur (9) de courant maximum pour obtenir des courants intenses nécessaires pour le contrôle, dans lequel on utilise un cycle de contrôle, qui comprend des phases A à D se succédant dans le temps, produites par commande des modules (16) d'onduleur sous tension :

A :

tension positive au côté primaire du transformateur (9) de courant maximum,

B :

tension nulle au côté primaire du transformateur (9) de courant maximum,

C :

tension négative au côté primaire du transformateur (9) de courant maximum,

dans lequel, dans une phase D, suivant directement dans le temps la tension négative, du cycle de contrôle, on met les modules (16) d'onduleur sous tension, dans un état indéfini, qui est un état à grande puissance ohmique de tous les transistors (25) des modules (16) d'onduleur, et

dans lequel on mesure la longueur de la phase D dans le temps de l'état indéfini, de manière à faire décroître un flux magnétique établi dans le transformateur (9) de courant maximum, dans lequel plusieurs cycles de contrôle de même type se succèdent, dans lequel chaque cycle de contrôle comprend les phases A, B, C et D, dans cet ordre.

2. Procédé suivant la revendication 1, dans lequel on utilise comme transistor (25) respectif, un transistor (25) bipolaire à électrode (25) de grille isolée.

3. Procédé suivant l'une des revendications précédentes, dans lequel le module (16) d'onduleur sous tension respectif est conçu pour une tension nominale de plus de 800 V et/ou un courant nominal de plus de 500 A.

4. Procédé suivant l'une des revendications précédentes, dans lequel on utilise plus de cinq, de préférence plus de dix modules (16) d'onduleur sous tension.

5. Procédé suivant l'une des revendications précédentes, dans lequel on utilise un thyristor (11) comme élément (11) à semiconducteur de haute puissance.

6. Circuit (20) de contrôle ayant une électronique de commande, conçu pour le contrôle d'un élément (11) à semiconducteur de haute puissance d'onduleurs d'un transport de courant continu sous haute tension par un procédé suivant l'une des revendications précédentes,

comprenant une pluralité de modules (16) d'onduleur sous tension, qui sont montés en série et qui sont reliés au côté primaire d'un transformateur (9) de courant maximum, et dans lequel le côté secondaire du transformateur (9) de courant maximum est relié à l'élément (11) à semiconducteur de haute puissance,

dans lequel les modules (16) d'onduleur sous tension comprennent chacun un condensateur (27) et quatre transistors (25) ayant chacun, en un pont complet, une diode (26) de roue libre, comprenant une source (28) de haute tension, qui comprend les modules (16) d'onduleur sous tension montés en série, dans lequel le circuit (20) de contrôle est conçu pour reproduire, pour l'élément (11) à semiconducteur de haute puissance, des courbes de courant se produisant par ces modules (16) d'onduleur, dans le fonctionnement de transport de courant continu sous haute tension, et pour obtenir ainsi des courants intenses nécessaires pour le contrôle, au moyen du transformateur (9) de courant maximum, dans lequel le circuit (20) de contrôle est conçu pour utiliser un cycle de contrôle, qui comprend les phases A à D se succédant dans le temps, produites par commande des modules (16) d'onduleur sous tension :

A :

tension positive au côté primaire du transformateur (9) de courant maximum,

B :

tension nulle au côté primaire du transformateur (9) de courant maximum,

C :

tension négative au côté primaire du transformateur (9) de courant maximum,

dans lequel, dans une phase D, suivant directement dans le temps la tension négative, du cycle de contrôle, on met les modules (16) d'onduleur sous tension, dans un état indéfini, qui est un état à grande puissance ohmique de tous les transistors (25) des modules (16) d'onduleur, et

dans lequel on mesure la longueur de la phase D dans le temps de l'état indéfini, de manière à faire décroître un flux magnétique établi dans le transformateur (9) de courant maximum, dans lequel plusieurs cycles de contrôle de même type se succèdent, dans lequel chaque cycle de contrôle comprend les phases A, B, C et D, dans cet ordre.

FIG 1

FIG 2

FIG 3

FIG 4

## FIG 5

## FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2014056540 A1

**In der Beschreibung aufgeführte Nicht-Patentliteratur**

- Thyristor valves for high voltage direct current (HVDC) power transmission, Part1: Electrical Testing. IEC (International Electrotechnical Commission), 2008

- Static var compensators (SVC) - Testing of thyristor valves. IEC (International Electrotechnical Commission), 2011
- IEEE 857, Guide for Testing of Thyristor Valves. IEEE (Institute of Electrical and Electronics Engineers, 1996